# EUROPEAN PATENT APPLICATION

(11) **EP 3 457 426 A1**
(43) Date of publication of application: **20.03.2019**
(21) Application number: 18189565.7
(22) Date of filing: 17.08.2018
(51) Int. Cl.: H01J 37/09, H01J 37/317, H01J 37/147, H01J 37/28

(54) **CHARGED PARTICLE BEAM DEVICE, APERTURE ARRANGEMENT FOR A CHARGED PARTICLE BEAM DEVICE, AND METHOD FOR OPERATING A CHARGED PARTICLE BEAM DEVICE**

(30) Priority: 29.08.2017 US 201715689311
(71) Applicant: ICT Integrated Circuit Testing Gesellschaft für Halbleiterprüftechnik mbH, 85551 Heimstetten (DE)
(72) Inventor: Frosien, Jürgen, 85521 Riemerling (DE)
(74) Representative: Zimmermann & Partner Patentanwälte mbB

(57) **Abstract**

The present disclosure provides a charged particle beam device (100). The charged particle beam device (100) includes a charged particle source (20) configured to emit a charged particle beam (14), a condenser lens arrangement (110), an aperture arrangement (120) configured to generate two or more beamlets of the charged particle beam (14), wherein the aperture arrangement (120) includes a plurality of first openings and a plurality of second openings different from the plurality of first openings, and a multipole arrangement (130) configured to act on the two or more beamlets. The aperture arrangement (120) is configured to align the plurality of first openings or the plurality of second openings with the multipole arrangement (130).

## Description

### FIELD

Embodiments of the present disclosure relate to a charged particle beam device, an aperture arrangement for a charged particle beam device, and a method for operating a charged particle beam device. Embodiments of the present disclosure particularly relate to electron beam inspection (EBI).

### BACKGROUND

Charged particle beam devices have many functions in a plurality of industrial fields, including, but not limited to, electron beam inspection (EBI), critical dimension (CD) measurements of semiconductor devices during manufacturing, defect review (DR) of semiconductor devices during manufacturing, exposure systems for lithography, detecting devices and testing systems. Thus, there is a high demand for structuring, testing and inspecting specimens within the micrometer and nanometer scale. Micrometer and nanometer scale process control, inspection or structuring can be done with charged particle beams, e.g. electron beams, which are generated and focused in charged particle beam devices, such as electron microscopes. Charged particle beams offer superior spatial resolution compared to, for example, photon beams due to the short wavelengths.

High throughput electron beam inspection (EBI) systems can utilize multibeam charged particle beam devices, such as electron microscopes, that are able to create, focus and scan multiple primary charged particle beams inside a single column of the charged particle beam device. A sample can be scanned by an array of focused primary charged particle beams, which in turn create multiple signal charged particle beams. The individual signal charged particle beams can be mapped onto detection elements.

It can be beneficial to operate charged particle beam devices in different operation modes. Switching from one operation mode to another operation mode can include extensive hardware changes and/or changes in the secondary imaging/detection optics. Hardware changes increase a downtime of the charged particle beam device. Further, hardware changes can be cumbersome and may only be done by highly skilled personnel. Changing the secondary imaging/detection optics may include time consuming recalibrations.

In view of the above, a charged particle beam device, an aperture arrangement for a charged particle beam device, and a method for operating a charged particle beam device that overcome at least some of the problems in the art are beneficial. The present disclosure particularly aims at providing a flexible charged particle beam device having multiple operation modes.

### SUMMARY

In light of the above, a charged particle beam device, an aperture arrangement for a charged particle beam device, and a method for operating a charged particle beam device are provided. Further aspects, benefits, and features of the present disclosure are apparent from the claims, the description, and the accompanying drawings.

According to an aspect of the present disclosure, a charged particle beam device is provided. The charged particle beam device includes a charged particle source configured to emit a charged particle beam, a condenser lens arrangement of one or more lenses, an aperture arrangement configured to generate two or more beamlets of the charged particle beam, wherein the aperture arrangement includes a plurality of first openings and a plurality of second openings different from the plurality of first openings, and a multipole arrangement configured to act on the two or more beamlets. The aperture arrangement is configured to align the plurality of first openings or the plurality of second openings with the multipole arrangement.

According to another aspect of the present disclosure, an aperture arrangement for a charged particle beam device is provided. The aperture arrangement includes a first aperture assembly having a plurality of first openings and a second aperture assembly having a plurality of second openings, wherein a diameter of the plurality of first openings is different from a diameter of the plurality of second openings, and an actuator assembly configured to move the first aperture assembly and the second aperture assembly.

According to yet another aspect of the present disclosure, a method for operating a charged particle beam device is provided. The method includes operating the charged particle beam device in a first operation mode using a first aperture assembly having a plurality of first openings to generate two or more beamlets of a charged particle beam, and operating the charged particle beam device in a second operation mode using a second aperture assembly having a plurality of second openings different from the plurality of first openings.

Embodiments are also directed at apparatuses for carrying out the disclosed methods and include apparatus parts for performing each described method aspect. These method aspects may be performed by way of hardware components, a computer programmed by appropriate software, by any combination of the two or in any other manner. Furthermore, embodiments according to the disclosure are also directed at methods for operating the described apparatus. The method includes method aspects for carrying out every function of the apparatus.

### BRIEF DESCRIPTION OF THE DRAWINGS

So that the manner in which the above recited features of the present disclosure can be understood in detail, a more particular description of the disclosure, briefly summarized above, may be had by reference to embodiments. The accompanying drawings relate to embodiments of the disclosure and are described in the following:
- FIG. 1: shows a schematic view of a charged particle beam device according to embodiments described herein;
- FIG. 2: shows a schematic view of a section of a charged particle beam device according to embodiments described herein;
- FIG. 3: shows a schematic view of a section of a charged particle beam device according to further embodiments described herein;
- FIG. 4: shows a schematic view of a section of a charged particle beam device according to yet further embodiments described herein;
- FIG. 5: shows a schematic view of a section of a charged particle beam device according to embodiments described herein;
- FIG. 6: shows a schematic view of a section of a charged particle beam device according to further embodiments described herein;
- FIG. 7: shows a flowchart of a method for operating a charged particle beam device according to embodiments described herein; and
- FIG. 8: shows operation modes of the charged particle beam device according to embodiments described herein.

### DETAILED DESCRIPTION OF EMBODIMENTS

Reference will now be made in detail to the various embodiments of the disclosure, one or more examples of which are illustrated in the figures. Within the following description of the drawings, the same reference numbers refer to same components. Only the differences with respect to individual embodiments are described. Each example is provided by way of explanation of the disclosure and is not meant as a limitation of the disclosure. Further, features illustrated or described as part of one embodiment can be used on or in conjunction with other embodiments to yield yet a further embodiment. It is intended that the description includes such modifications and variations.

Without limiting the scope of protection of the present application, in the following the charged particle beam device or components thereof will exemplarily be referred to as a charged particle beam device using electrons as charged particles. However, other types of primary charged particles, e.g. ions, could be used. Upon irradiation of a specimen or sample by a charged particle beam (also referred to as "primary charged particle beam"), signal charged particles, such as secondary electrons (SE), are created, which may carry information about the topography, chemical constituents and/or electrostatic potential of the sample and others. The secondary electrons can include at least one of backscattered electrons and Auger electrons. The signal charged particles can be collected and guided to a sensor, e.g., a scintillator, a pin diode or the like.

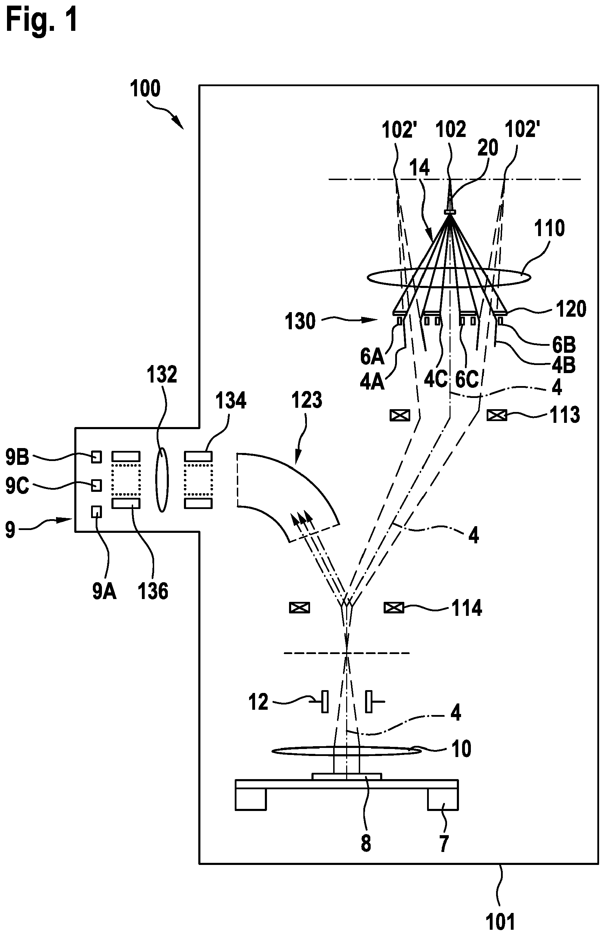

High throughput electron beam inspection (EBI) systems can utilize multibeam charged particle beam devices, such as electron microscopes, that are able to create, focus and scan multiple primary charged particle beams or beamlets inside a single column of the charged particle beam device. A sample can be scanned by an array of focused primary charged particle beamlets, which in turn create multiple signal charged particle beams one or beamlets. The individual signal charged particle beamlets can be mapped onto one or detection elements. For example, the signal charged particle beamlets can be detected on-axis or, as is illustrated in FIG. 1, off-axis.

The present disclosure uses two or more sets of openings (also referred to as "apertures") to generate two or more beamlets of a charged particle beam. The two or more sets of openings can be moved such that either a set of first openings of the two or more sets of openings is positioned in the beam path of the primary charged particle beam or a second set of second openings of the two or more sets of openings is positioned in the beam path of the primary charged particle beam. The first openings and the second openings are different, e.g., in diameter. The first openings can be used for (or, at least in part, provide) a first operation mode, such as an imaging mode, and the second openings can be used for (or, at least in part, provide) a second operation mode, such as a charging mode.

The present disclosure further uses a multipole arrangement acting on the two or more beamlets created by the aperture set. The multipole arrangement is arranged in one or more stages or layers. Each stage or layer may implement one or more functionalities, such as beamlet deflection, aberration correction, and blanking. The functionalities can be distributed among the stages. For example, one stage can implement one or more functions, and another stage can implement one or more other functions. The stages or layers can be independent from each other.

Accordingly, the present disclosure can provide a flexible and optimized charged particle beam device (or column) e.g. regarding probe size and/or probe current or landing energy. Different operation modes can be flexibly provided (e.g., imaging, charging, decay time effects). The switching between operation modes can be done with a minimum effort in (column) hardware changes.

FIG. 1 shows a schematic view of a charged particle beam device 100 according to embodiments described herein. The charged particle beam device 100 can be an electron microscope, such as a scanning electron microscope (SEM). The charged particle beam device 100 includes a column having a column housing 101.

The charged particle beam device 100 includes a charged particle source 20 configured to emit a (primary) charged particle beam 14, a condenser lens arrangement 110, an aperture arrangement 120 configured to generate two or more beamlets 4A, 4B, 4C of the charged particle beam 14, and a multipole arrangement 130 configured to act on the two or more beamlets 4A, 4B, 4C. The aperture arrangement 120 includes a plurality of first openings and a plurality of second openings different from the plurality of first openings, and a multipole arrangement 130 configured to act on the two or more beamlets. The aperture arrangement 120 is configured to align either the plurality of first openings or the plurality of second openings with the multipole arrangement 130.

According to some embodiments, which can be combined with other embodiments described herein, one single charged particle source can be provided. The charged particle source 20 can be a high brightness gun. For example, the charged particle source 20 can be selected from the group including a cold field emitter (CFE), a Schottky emitter, a TFE, or another high current e-beam source.

The condenser lens arrangement 110 illuminates the aperture arrangement 120 with the (primary) charged particle beam 14, such as an electron beam. The resulting two or more beamlets 4A, 4B, and 4C can be deflected using deflectors 6A, 6B and 6C of the multipole arrangement 130 such that the two or more beamlets 4A, 4B, and 4C appear to come from different sources. For example, the electrons of the beamlets appear to be emitted from different locations in a plane of the charged particle source 20 perpendicular to an optical axis 4. As shown in FIG. 1, the electrons provided by the source appear to come from a virtual source 102 due to the action of the condenser lens arrangement 110. Further, there can be sources 102' due to the combined action of the deflectors 6A and 6B and the condenser lens arrangement 110. The center source may correspond to the charged particle source 20. The other sources can be virtual sources with an off-set in a plane perpendicular to the optical axis 4.

According to some embodiments, which can be combined with other embodiments described herein, a beam separator, i.e., a separator separating the primary beamlets from the signal beamlets, can be provided by magnetic deflectors, such as the magnetic deflector 113 and the beam separator 114. A scanning deflector 12 may scan the beam or beamlets over the surface of the sample 8. The primary beamlets, i.e. the two or more beamlets, are focused on the specimen or sample 8 using a common objective lens. All of the primary beamlets can pass through one opening in the objective lens 10. The sample 8 is provided on a sample stage 7, which can be configured to move the sample 8 in at least one direction perpendicular to the optical axis 4.

A "sample" or "specimen" as referred to herein, includes, but is not limited to, semiconductor wafers, semiconductor workpieces, and other workpieces such as memory disks and the like. Embodiments of the disclosure may be applied to any workpiece on which material is deposited or any workpiece which is structured. Upon irradiation of the sample 8 by the electron beam, signal charged particles, such as secondary electrons (SE), are created, which may carry information about the topography, chemical constituents and/or electrostatic potential of the sample and others. The secondary electrons can include at least one of backscattered electrons and Auger electrons. The signal charged particles can be collected and guided to a detector device, which can be a sensor, e.g., a scintillator, a pin diode or the like.

According to some embodiments, which can be combined with other embodiments described herein, the objective lens 10 can be an electrostatic magnetic compound lens, particularly having an electrostatic lens that reduces the energy within the column from a high energy within the column to a lower landing energy. The energy reduction from the column energy to the landing energy can be at least a factor of 10, for example at least a factor of 30.

In some implementations, a retarding field including a potential provided to the sample 8 can be provided. According to yet further implementations, which can be combined with other embodiments described herein, a configuration, in which the column is at ground potential and the charged particle source 20 and the sample 8 are at a high potential can be provided. For example, most or all of the column components can be provided at ground potential.

As for instance shown in FIG. 1, all primary beamlets can be scanned across the surface of the sample 8 using a common scanning deflector. According to some embodiments, which can be combined with other embodiments described herein, the scanning deflector 12 can be within the objective lens 10 or close to the objective lens 10. According to some embodiments, which can be combined with other embodiments described herein, the scanning deflector 12 can be an electrostatic and/or magnetic octupole.

The charged particle beam device 100 shown in FIG. 1 includes a signal electron optics. Particles released from or backscattered from the sample 8 form signal beamlets carrying information about the sample 8. The information can include information about the topography of the sample 8, the chemical constituents, the electrostatic potential, and others. The signal beamlets are separated from the primary beamlets using the beam separator 114 and enter a beam bender 123. The beam separator can, for example, include at least one magnetic deflector, a Wien filter, or any other devices, wherein the electrons are directed away from the primary beam, e.g. due to the velocity depending Lorenz force.

The beam bender 123 deflects the secondary beamlets towards a focusing lens 132. The focusing lens 132 focuses signal beamlets on detector elements 9A, 9B and 9C, such as sensors, scintillators, pin diodes or the like, of a detector assembly 9. According to other embodiments focusing of the secondary beamlets can be performed by a lens system which enables calibration of magnification and rotation. According to some embodiments, one or more deflectors 134, 136 are provided along the path of the signal beamlets.

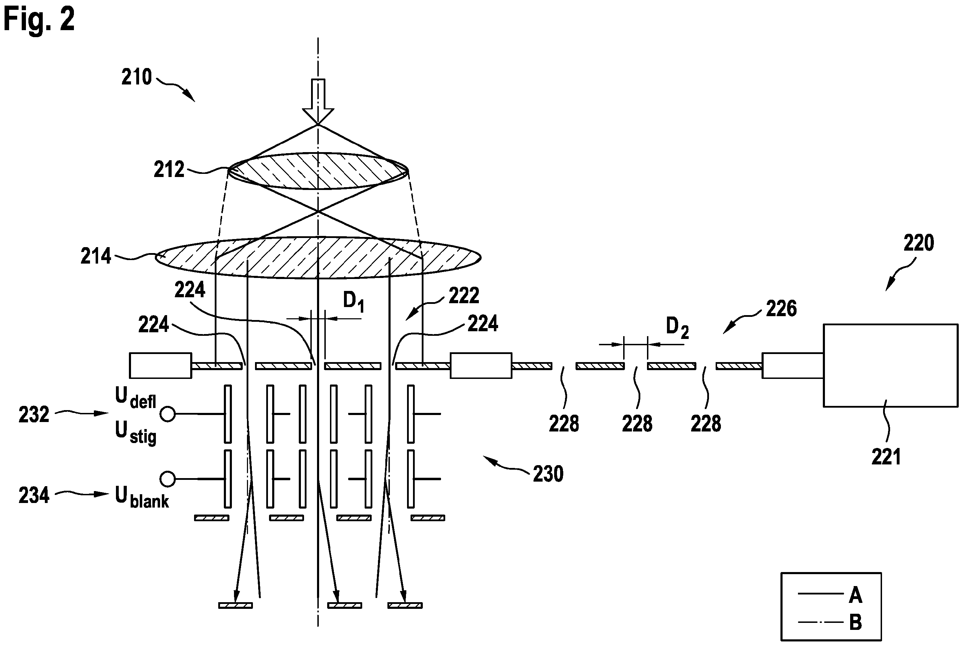

FIG. 2 shows a schematic view of a section of a charged particle beam device according to embodiments described herein. The charged particle beam device includes the condenser lens arrangement 210, the aperture arrangement 220, and the multipole arrangement 230.

According to some embodiments, which can be combined with other embodiments described herein, the condenser lens arrangement 210 includes one or more condenser lenses, such as a single condenser lens or two or more condenser lenses. FIG. 2 illustrates an exemplary condenser lens arrangement having two or more condenser lenses, such as a first condenser lens 212 and a second condenser lens 214. The condenser lens arrangement 210 can be configured to provide a beam path A with cross-over and/or a beam path B without cross-over. The beam path A with cross-over has less stray field sensitivity. The beam path B without cross-over reduces electron-electron interaction.

The condenser lens arrangement 210 is configured to illuminate the aperture arrangement 220. The condenser lens arrangement 210 can have an adjustable lens excitation for at least one of changing a focal length and changing an illumination angle of the multipole arrangement 220. For example, the condenser lens arrangement 210 can be provided with a controllable lens excitation for a focal length change enabling a variable source magnification and/or demagnification. Additionally or alternatively, the condenser lens arrangement 210 can be provided with the controllable lens excitation for controlling the illumination angle of the aperture arrangement 220 and/or the multipole arrangement 230 (e.g., a deflector array). In some implementations, the condenser lens arrangement 210 can provide an essentially parallel illumination of the aperture arrangement 220 and/or the multipole arrangement 230.

The aperture arrangement 220 includes a first aperture assembly 222 having a plurality of first openings 224 (a set of first openings or apertures) and a second aperture assembly 226 having a plurality of second openings 228 (a set of second openings or apertures). The plurality of first openings 224 is different from the plurality of second openings 228. For example, a diameter D1 or shape of the plurality of first openings 224 is different from a diameter D2 or shape of the plurality of second openings 228. In some implementations, the plurality of first openings 224 and/or the plurality of second openings 228 can have an essentially circular shape, wherein the diameter can be defined as a diameter of the individual circles. According to some embodiments, the openings of the plurality of first openings 224 are essentially identical, e.g., have essentially the same diameter or shape. Likewise, the openings of the plurality of second openings 228 can be essentially identical, e.g., have essentially the same diameter or shape.

According to some embodiments, which can be combined with other embodiments described herein, the diameter of the plurality of first openings 224 and/or the diameter of the plurality of second openings 228 can be in a range of 1 micrometer to 2000 micrometer, specifically in a range of 10 micrometer to 400 micrometer, and more specifically in a range of 20 micrometer to 200 micrometer. A difference between the diameters can be a factor in a range of 0.5 to 50, and specifically in a range of 1.5 to 10. For example, the diameter of the plurality of first openings 224 can be the factor (e.g. 0.5) times the diameter of the plurality of second openings 228. Or, the diameter of the plurality of second openings 228 can be the factor (e.g. 0.5) times the diameter of the plurality of first openings 224.

Either the first aperture assembly 222 having the plurality of first openings 224 or the second aperture assembly 226 having the plurality of second openings 228 can be arranged in the beam path of the (primary) charged particle beam to create the two or more beamlets. In particular, the openings can be aligned with respect to the multipole arrangement 230 such that the two or more beamlets can pass through respective multipoles of the multipole arrangement 230. A beamlet of the two or more beamlets can, in some implementations, pass through a center of a multipole, or can pass off-axis or off-center through the multipole. The different openings can provide, at least in part, different operation modes, such as an imaging mode e.g. with different probe currents and a charging mode. The aperture array exchanger has different sets of apertures arranged in the deflector array configuration/geometry having different sizes whose diameters are optimized to generate an optimum.

According to some embodiments, which can be combined with other embodiments described herein, the aperture arrangement 220 further includes an actuator assembly 221 configured to move the first aperture assembly 222 and the second aperture assembly 226. For example, the aperture arrangement 220 can include at least a first aperture plate having the plurality of first openings 224 and a second aperture plate having the plurality of second openings 228. The actuator assembly 221 can be configured to move the first aperture plate and the second aperture plate. The actuator assembly 221 can be configured to move the first aperture assembly 222 into the beam path of the primary charged particle beam and optionally to move the second aperture assembly 226 out of the beam path of the primary charged particle beam to change an operation mode of the charged particle beam device to a first operation mode. Likewise, the actuator assembly 221 can be configured to move the second aperture assembly 226 into the beam path of the primary charged particle beam and optionally to move the first aperture assembly 222 out of the beam path of the primary charged particle beam to change an operation mode of the charged particle beam device to a second operation mode different from the first operation mode. Only apertures are replaced (for different probe sizes or currents, for reduction of contamination influences). The multipole MEMS including wiring and driver can be identical in all operation modes.

According to some embodiments, the actuator assembly 221 includes a rotary actuator configured to rotate the first aperture assembly 222, such as the first aperture plate, and the second aperture assembly 226, such as the second aperture plate, around a rotational axis. The rotational axis can be located between the first aperture assembly 222 and the second aperture assembly 226. The rotational axis can be essentially parallel to the optical axis defined by the condenser lens arrangement 210 and/or a plane in which the plurality of first openings 224 and the plurality of second openings 228 are arranged. The rotary actuator can be configured to rotate the first aperture assembly 222 into the beam path of the primary charged particle beam and optionally to rotate the second aperture assembly 226 out of the beam path of the primary charged particle beam to change an operation mode of the charged particle beam device to a first operation mode. Likewise, the rotary actuator can be configured to rotate the second aperture assembly 226 into the beam path of the primary charged particle beam and optionally to rotate the first aperture assembly 222 out of the beam path of the primary charged particle beam to change an operation mode of the charged particle beam device to a second operation mode different from the first operation mode.

In some implementations, the rotational axis can be an essentially vertical rotational axis. The term "vertical direction" or "vertical orientation" is understood to distinguish over "horizontal direction" or "horizontal orientation". That is, the "vertical direction" or "vertical orientation" relates to a substantially vertical orientation e.g. of the rotational axis, wherein a deviation of a few degrees, e.g. up to 10° or even up to 15°, from an exact vertical direction or vertical orientation is still considered as a "substantially vertical direction" or a "substantially vertical orientation". The vertical direction can be substantially parallel to the force of gravity.

In some implementations, the actuator assembly includes an x-y actuator stage configured to align the plurality of first openings 224 or the plurality of second openings 228 with the multipole arrangement 230. For example, the rotary actuator can rotate the first aperture assembly 222 and the second aperture assembly 226 to provide either the first aperture assembly 222 or the second aperture assembly 226 in the beam path of the primary charged particle beam. The x-y actuator stage can then align the plurality of openings with the multipole arrangement 230. For example, the x-y actuator stage can be configured to precisely align the different aperture arrays to or close to the individual axis of the individual deflectors in the deflector array applied for (virtual) source multiplication.

According to some embodiments, which can be combined embodiments described herein, the multipole arrangement 230 includes two or more multipoles. The two or more multipoles can be selected from the group including a dipole, a quadrupole, a hexapole and an octopole. The multipole arrangement 230 can be configured at least one of to deflect the two or more beamlets, to correct aberrations, and to selectively blank the two or more beamlets. The two or more multipoles can be selected based on the function(s). For example, an octopole configuration can be used to correct astigmatism and/or can be used to correct a threefold beam deformation. In particular, an octopole electrode arrangement can be used for stigmation control but can also generate a hexapole field to correct a threefold beam deformation.

In some implementations, the charged particle beam device includes at least one voltage source. The at least one voltage source can be configured to apply at least one of a first voltage U_{defl} to the multipole arrangement 223 to deflect the two or more beamlets, a second voltage U_{stig} to correct aberrations, and a third voltage U_{blank} to selectively blank the two or more beamlets. The at least one voltage source can be configured to superimpose at least two voltages of the first voltage, the second voltage, and the third voltage. In the example of FIG. 2, the first voltage U_{defl} and the second voltage U_{stig} are superimposed.

According to some embodiments, which can be combined with other embodiments described herein, the multipole arrangement includes two or more multipole stages (also referred to as "multipole layers"). The two or more multipole stages can be successively arranged or stacked along the optical axis between the aperture arrangement 220 and the sample stage and/or an objective lens. For example, each multipole stage of the two or more multipole stages can include two or more multipoles, such as dipoles, quadrupoles, hexapoles, or octopoles. A respective multipole can be provided for each one of the two or more beamlets.

In some implementations, the two or more multipole stages include a first multipole stage having two or more first multipoles and a second multipole stage having two or more second multipoles. In the example of FIG. 2, the first voltage U_{defl} and the second voltage U_{stig} are superimposed and applied to the two or more first multipoles of the first multipole stage or layer. The third voltage U_{blank} is applied to the two or more second multipoles of the second multipole stage or layer.

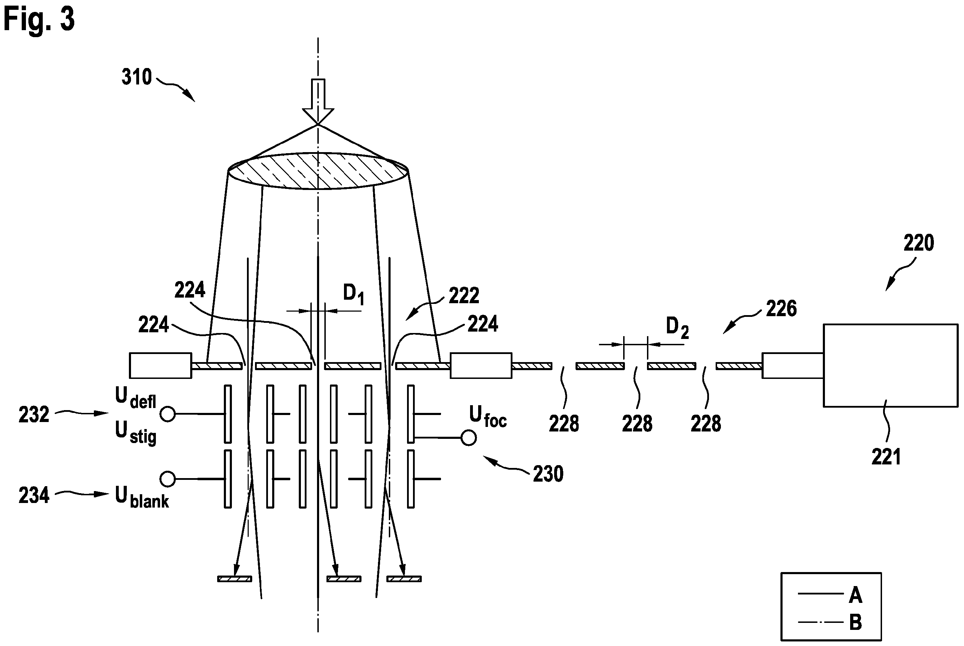

In some implementations, the first multipole stage 232 can include an octopole arrangement for deflection, astigmatism and hexapole control. Optionally, the first multipole stage 232 can be configured for focus correction e.g. by supplying a common voltage to all electrodes of the octopole. The second multipole stage 234 can be configured as a beamlet blanker. The second multipole stage 234 can for instance have a dipole arrangement (also as higher multiple architecture). The second multipole stage 234 can implement one or more further functionalities, such as a fine x-y-alignment of the two or more beamlets. The functionality between the stages or layers can be reversed or differently divided. Further examples are illustrated in FIGs. 3 to 6.

According to some embodiments, which can be combined with other embodiments described herein, the aperture arrangement 220, such as the aperture plate(s), and the multipole arrangement 230, such as the double deflector unit illustrated in FIG. 2, are provided as separate modules. For changing the operation mode, only the apertures are replaced. The wiring and/or the drivers can be identical in all operation modes.

FIG. 3 shows a schematic view of a section of a charged particle beam device according to further embodiments described herein. The charged particle beam device includes the condenser lens arrangement 310, the aperture arrangement 220, and the multipole arrangement 230. The condenser lens arrangement 310 has a single condenser lens. The configuration illustrated in FIG. 3 is similar to the configuration of FIG. 2 and a description of similar or identical elements is not repeated.

The multipole arrangement 230 includes the first multipole stage 232 having two or more first multipoles and the second multipole stage 234 having two or more second multipoles. In the example of FIG. 3, the first voltage U_{defl} and the second voltage U_{stig} are superimposed and applied to the two or more first multipoles of the first multipole stage or layer. The third voltage U_{blank} is applied to the two or more second multipoles of the second multipole stage or layer. Additionally, a fourth voltage U_{foc} is applied to the first multipole stage 232. The first voltage U_{defl}, the second voltage U_{stig}, and the fourth voltage U_{foc} can be superimposed. The fourth voltage U_{foc} can be provided for focus control. For example, the first multipole stage 232 can have an octopole arrangement for deflection, astigmatism, and focus control.

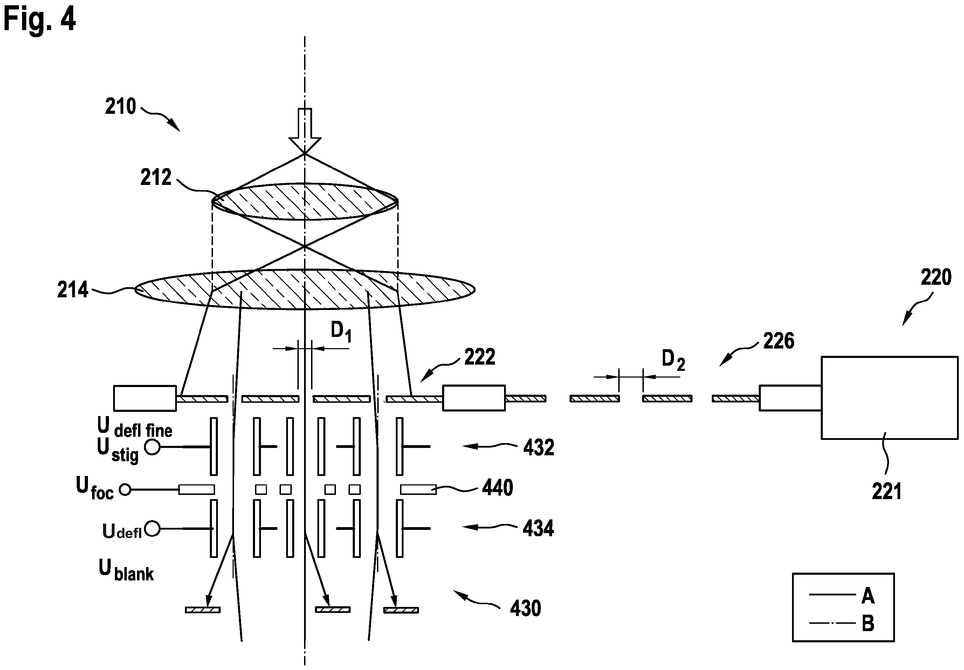

FIG. 4 shows a schematic view of a section of a charged particle beam device according to embodiments described herein. The charged particle beam device includes the condenser lens arrangement 210, the aperture arrangement 220, and a 3-stage multipole arrangement 430. The condenser lens arrangement 210 is a condenser lens system having two condenser lenses.

According to some embodiments, which can be combined with other embodiments described herein, the charged particle beam device, and particularly the multipole arrangement 430, the first multipole stage, the second multipole stage, and a third multipole stage. The first multipole stage, the second multipole stage, and the third multipole stage can be successively arranged along a beam path of the two or more beamlets.

According to some embodiments, which can be combined with other embodiments described herein, the charged particle beam device, and particularly the multipole arrangement 430, includes a focusing lens array 440 between the multipole stages 432 and 434. For example, the focusing lens array 440 can be a further multipole stage (e.g., the second or third multipole stage) that includes two or more further multipoles.

In some implementations, the first multipole stage, the second multipole stage, and the third multipole stage are independent from each other. For example, voltages can be independently applied to each of the first multipole stage, the second multipole stage, and the third multipole stage. The first multipole stage, the second multipole stage, and the third multipole stage can provide two or more functionalities. The two or more functionalities can be distributed among the first multipole stage, the second multipole stage, and the third multipole stage. The two or more functionalities can be selected from the group consisting of beamlet deflection, aberration correction, beamlet alignment, field curvature correction, focus correction, fine focus correction, astigmatism control, and beamlet blanking.

In the example of FIG. 4, a voltage U_{defl}, _{fine} for fine deflection to align the beam on the optical axis of the lens array (second) stage 440 and a voltage U_{stig} for astigmatism control are superimposed and applied to the (first) multipole stage 432. In particular, each individual lens of the lens array can have an optical axis to which a respective beamlet is aligned. The (first) multipole stage 432 can be an octopole stage. The second stage 440 can be a round electrode array or a multipole array.

A voltage U_{foc} for focus control (e.g. field curvature correction and/or fine focus) can be applied to the (second) multipole stage, such as the focusing lens array 440. The (second) multipole stage can include one or more round electrodes or multipoles in higher order, e.g. octopoles, with a common voltage which can take over other functionalities (because of a pre-alignment in the first multipole stage 432 a beamlet passes an Einzel lens on-axis).

A voltage U_{defl} for deflecting beamlets towards an objective lens and a voltage U_{blank} for blanking beamlets are superimposed and applied to the (third) multipole stage 434. The 3 layers can create individual Einzel lenses.

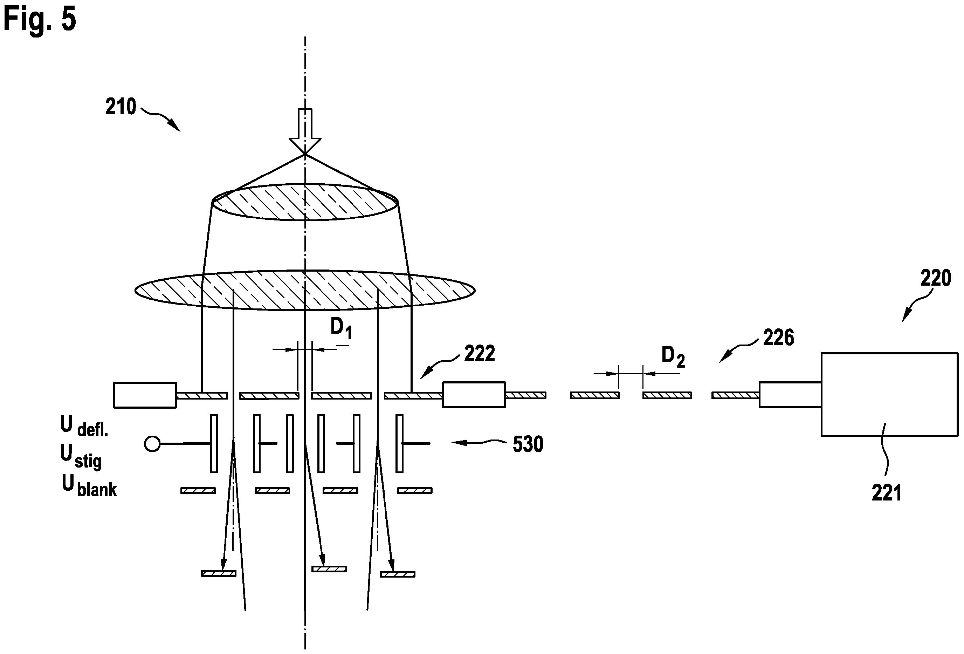

FIG. 5 shows a schematic view of a section of a charged particle beam device according to embodiments described herein. The charged particle beam device includes the condenser lens arrangement 210, the aperture arrangement 220, and a 1-stage multipole arrangement 530. The condenser lens arrangement 210 is a condenser lens system having two condenser lenses without crossover.

In the example of FIG. 5, all functionalities are realized in one layer, for example, by octopoles. For example, a first voltage U_{defl} to deflect the two or more beamlets, a second voltage U_{stig} to correct aberrations, and a third voltage U_{blank} to selectively blank the two or more beamlets are applied to the single stage. The first voltage, the second voltage, and the third voltage can be superimposed to provide the respective functionalities.

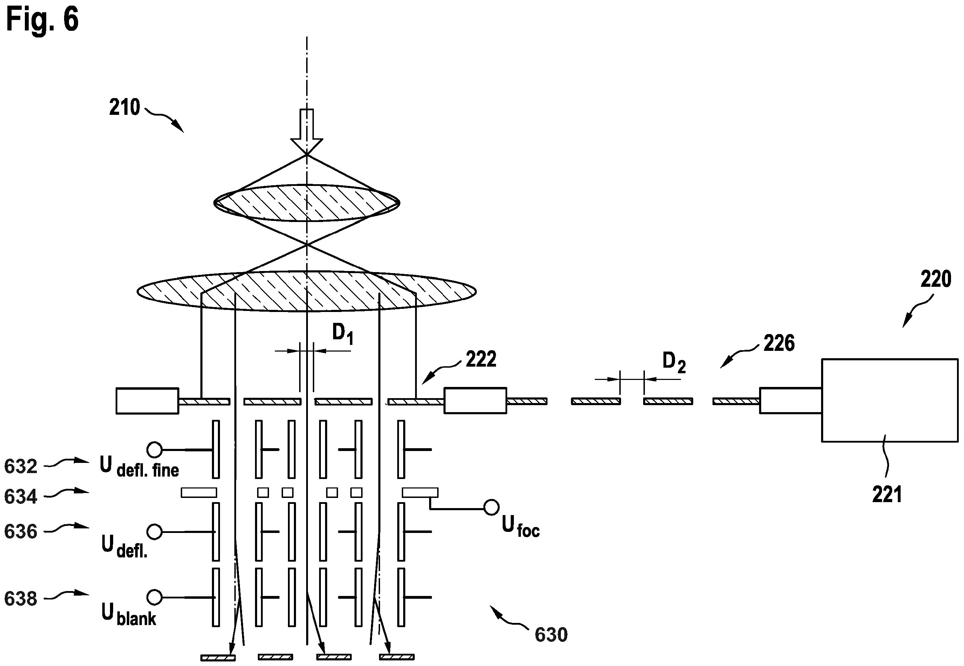

FIG. 6 shows a schematic view of a section of a charged particle beam device according to embodiments described herein. The charged particle beam device includes the condenser lens arrangement 210, the aperture arrangement 220, and a 4-stage multipole arrangement 630. The condenser lens arrangement 210 is a condenser lens system having two condenser lenses.

According to some embodiments, which can be combined with other embodiments described herein, the charged particle beam device, and particularly the multipole arrangement 630, includes the first multipole stage 632, the second multipole stage 634, the third multipole stage 636, and a fourth multipole stage 638. The first multipole stage 632, the second multipole stage 634, the third multipole stage 636, and the fourth multipole stage 638 can be successively arranged along a beam path of the two or more beamlets.

In the example of FIG. 6, a voltage U_{defl, fine} for fine deflection is applied to the first multipole stage 632. The second multipole stage 634 can be a focusing lens array. A voltage U_{foc} for focus control (e.g. field curvature correction and/or fine focus) can be applied to the second multipole stage 634. A voltage U_{defl} for deflecting beamlets towards an objective lens can be applied to the third multipole stage 636. A voltage U_{blank} for blanking beamlets can be applied to the fourth multipole stage 638.

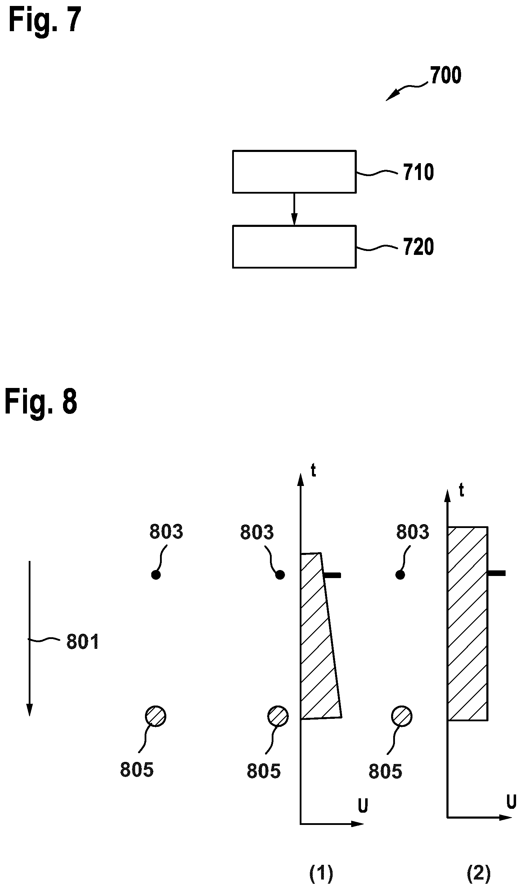

FIG. 7 shows a flowchart of a method 700 for operating a charged particle beam device according to embodiments described herein. The method 700 can be implemented using the apparatuses and systems described herein.

The method 700 includes in block 710 an operating of the charged particle beam device in a first operation mode using a first aperture assembly having a plurality of first openings to generate two or more beamlets of a charged particle beam, and in block 720 an operating of the charged particle beam device in a second operation mode using a second aperture assembly having a plurality of second openings different from the plurality of first openings.

In some implementations, the first operation mode uses a first condenser lens excitation and the second operation mode uses a second condenser lens excitation different from the first condenser lens excitation. The first operation mode and the second operation mode are selected from the group consisting of a sample imaging operation, a pre-charging operation, and a decay time inspection.

According to embodiments described herein, the method for operating a charged particle beam device can be conducted using computer programs, software, computer software products and the interrelated controllers, which can have a CPU, a memory, a user interface, and input and output devices being in communication with the corresponding components of the charged particle beam device.

FIG. 8 shows operation modes, and in particular for voltage contrast EBI, of the charged particle beam device according to embodiments described herein. In particular, a pre-charging and a decay time inspection are illustrated. Arrow 801 indicates a movement direction of a sample stage. Dots 803 indicate measuring/sampling beamlets having an optimized probe size. Dots 805 indicate flooding beamlets (large probe current by larger aperture). By dot 805 the surface of an insulating sample area is charged up. Case (1) shows a voltage drop based on a leakage on the sample for the flooding beamlets. Case (2) shows no voltage drop for the flooding beamlets.

The EBI multi-beamlet column architecture of the disclosure can use one high brightness electron source, a deflector array, at least one condenser lens, a set of selectable and alignable aperture arrays, and an objective lens. The high brightness electron source can provide a sufficient homogeneous emission angle to illuminate the aperture array. The deflector array virtually multiplies the one electron source into at least two sources and directs the multiplied beams towards the objective lens (e.g. hitting the objective lens axis near a center, a front focal point or a coma free point thereof). The at least one condenser lens is provided between the electron source and the deflector array for controlling the magnification/demagnification of the electron source. The set of selectable and alignable aperture arrays is provided in a configuration that corresponds with the configuration of the deflector array between that one source and that deflector array generating an array of beamlets. The objective lens focusses the beamlets on the sample surface.

At least 2 operation modes can be generated which are characterized by a certain beamlet probe size with optimized (e.g. max) probe current by choosing the appropriate condenser excitation and aperture size in the respective aperture array set determined by objective lens and condenser lens aberrations.

The embodiments described herein are only examples of possible configurations which can be combined and components/functionalities can be exchanged. The charged particle beam device according to the present disclosure particularly includes 4 individual components:

1. A high brightness electron source with sufficient constant angular intensity over a wide angle.

2. A condenser lens system having at least one condenser for probe size/probe current adjustment.

3. A beam deflector array module for virtually multiplying the electron source into an array of at least two which consists of at least one layer having at least one dipole per beamlet for directing the beamlets towards a common objective lens.

4. A separate plate with at least two multi-aperture arrays having same lateral architecture as the deflector array module (distances, pitch, geometrical arrangement) whereas the at least two aperture arrays have different aperture sizes (holes) and whereas the plate with the aperture arrays is moveable in such a way that the different aperture arrays can be positioned on and aligned with the axes of the deflector module.

The aperture diameter in the individual array groups can be chosen such that a highest current density in a pre-defined beamlet probe sizes can be achieved by at least one of setting a defined condenser lens magnification, and using optimum objective lens aperture angle defined by system magnification and lens aberrations (e.g. spherical and chromatic aberration).

Since a spot size selection/variation can be performed only by condenser lens system changes, and operation of the objective lens and a basic ray path of the objective lens can remain unchanged. The deflector module for source multiplication can direct the beamlets always to the same crossover point near the objective lens (e.g. front focal point or coma free point). The pitch of the beamlets on the sample surface can be constant (independent of probe size). Further, since the primary beamlet array configuration is constant, a detection of signal electrons is independent. The detection configuration/architecture (SE-optics, detector array) is can always be the same.

The deflector array configuration/architecture can have several options and components/functionalities:
- A basic function can be a beamlet deflection towards the objective lens. Here at least one radial deflection direction can be provide which is performed by a dipole field. This can be realized by a dipole electrode configuration or any higher multipole electrode configuration, like a quadrupole, sextupole, octopuole, and the like.
- For compensation of tolerances and deviations a deflection in 2 directions can be performed by two separate dipole electrodes, a quadrupole or a higher order multipole electrode configuration.
- For hexapole correction an electrode configuration with 6 electrodes can be used.

However, other higher order multipole electrode configurations can be used.
- For beamlet stigmatism control 2 orthogonal quadrupole fields can be used which can be realized by independent 2 quadrupoles, an octopole or higher order electrode configuration.
- In case that higher order effects influence beamlet performance, higher order multipole correction elements can be provided.
- For adding diffraction power (focusing) into the deflector array, a circular electrode can be integrated. Such a round lens field, however, can also be realized by any other (round) multipole electrode architecture by supplying a constant voltage to all electrodes.

The aforementioned functionalities can be realized in different layers of the deflector module or can be grouped in one or more layers. For example, deflection and stigmatism control can be combined in one octopole layer. How many layers and which combination of functionalities is performed can be selected based on system stability needs and tolerable flexibility of the overall module. FIG. 6 for instance shows a separation of static and dynamic (e.g. blanker) functionalities.

The layer structure of the defector module can be realized by stacking individual elements or by building one unit e.g. in MEMS technology or semiconductor manufacturing technology. The deflector array and aperture array layout can be of any 1-dimensional or 2-dimensional configuration which is practicable from the inspection application in particular which is supporting special beamlet scanning schemes.

While the foregoing is directed to embodiments of the disclosure, other and further embodiments of the disclosure may be devised without departing from the basic scope thereof, and the scope thereof is determined by the claims that follow.

## Claims

1. A charged particle beam device, comprising:
a charged particle source configured to emit a charged particle beam;
a condenser lens arrangement;
an aperture arrangement configured to generate two or more beamlets of the charged particle beam, wherein the aperture arrangement includes a plurality of first openings and a plurality of second openings different from the plurality of first openings; and
a multipole arrangement configured to act on the two or more beamlets,
wherein the aperture arrangement is configured to align the plurality of first openings or the plurality of second openings with the multipole arrangement.

2. The charged particle beam device of claim 1, wherein a diameter of the plurality of first openings is different from a diameter of the plurality of second openings.

3. The charged particle beam device of any of claims 1 to 2, wherein the aperture arrangement includes at least a first aperture plate having the plurality of first openings and a second aperture plate having the plurality of second openings, and wherein the charged particle beam device further includes an actuator assembly configured to move the first aperture plate and the second aperture plate.

4. The charged particle beam device of claim 3, wherein the actuator assembly includes a rotary actuator configured to rotate the first aperture plate and the second aperture plate around a rotational axis, particularly wherein the actuator assembly includes an x-y actuator stage configured to align the plurality of first openings or the plurality of second openings with the multipole arrangement.

5. The charged particle beam device of any of claims 1 to 4, wherein the condenser lens arrangement includes a single condenser lens or two or more condenser lenses, and wherein the condenser lens arrangement is configured to provide a beam path with cross-over or a beam path without cross-over, and/or wherein the condenser lens arrangement has an adjustable lens excitation for at least one of changing a focal length and changing an illumination angle of the multipole arrangement.

6. The charged particle beam device of any of claims 1 to 5, wherein the multipole arrangement is configured at least one of: to deflect the two or more beamlets, to correct aberrations, and to selectively blank the two or more beamlets.

7. The charged particle beam device of claim 6, further including at least one voltage source, wherein the at least one voltage source is configured to apply a first voltage to the multipole arrangement to deflect the two or more beamlets, a second voltage to correct aberrations, and a third voltage to selectively blank the two or more beamlets, particularly wherein the at least one voltage source is configured to superimpose at least two voltages of the first voltage, the second voltage, and the third voltage.

8. The charged particle beam device of any of claims 1 to 7, wherein the multipole arrangement includes a first multipole stage having two or more first multipoles and a second multipole stage having two or more second multipoles.

9. The charged particle beam device of claim 8, wherein the charged particle beam device further includes a focusing lens array between the first multipole stage and the second multipole stage, and/or wherein the multipole arrangement includes a third multipole stage having two or more third multipoles.

10. The charged particle beam device of claim 9, wherein the first multipole stage, the second multipole stage, and the third multipole stage are independent from each other, and/or wherein the first multipole stage, the second multipole stage, and the third multipole stage are successively arranged along a beam path of the two or more beamlets.

11. An aperture arrangement for a charged particle beam device, comprising:
a first aperture assembly having a plurality of first openings and a second aperture assembly having a plurality of second openings, wherein a diameter of the plurality of first openings is different from a diameter of the plurality of second openings; and
an actuator assembly configured to move the first aperture assembly and the second aperture assembly.

12. The aperture arrangement of clam 11, wherein the aperture arrangement is configured according to any of claims 1 to 10.

13. A method for operating a charged particle beam device, comprising:
operating the charged particle beam device in a first operation mode using a first aperture assembly having a plurality of first openings to generate two or more beamlets of a charged particle beam; and
operating the charged particle beam device in a second operation mode using a second aperture assembly having a plurality of second openings different from the plurality of first openings.

14. The method of claim 13, wherein the first operation mode uses a first condenser lens excitation and the second operation mode uses a second condenser lens excitation different from the first condenser lens excitation.

15. The method of claim 14, wherein the first operation mode and the second operation mode are selected from the group consisting of an sample imaging operation, a pre-charging operation, and a decay time inspection.
